(19) Europäisches Patentamt
European Patent Office
Office européen des brevets

(11) **EP 3 325 892 B1**

(12) **EUROPÄISCHE PATENTSCHRIFT**

(45) Veröffentlichungstag und Bekanntmachung des Hinweises auf die Patenterteilung:
**06.05.2020 Patentblatt 2020/19**

(21) Anmeldenummer: **16739149.9**

(22) Anmeldetag: **15.07.2016**

(51) Int Cl.:
*C23C 14/06* (2006.01)     *C23C 14/16* (2006.01)
*C23C 18/12* (2006.01)     *C25D 11/04* (2006.01)
*C25D 11/24* (2006.01)     *F24F 5/00* (2006.01)
*C23C 14/00* (2006.01)     *C25D 11/16* (2006.01)

(86) Internationale Anmeldenummer:
**PCT/EP2016/066908**

(87) Internationale Veröffentlichungsnummer:
**WO 2017/013017 (26.01.2017 Gazette 2017/04)**

(54) **HEIZ- UND KÜHLDECKENELEMENT, AUS BESCHICHTETEM ALUMINIUM**

CEILING ELEMENT FOR HEATING AND COOLING OF COATED ALUMINIUM

ÉLEMENT DE PLAFOND DE PLAFOND DE CHAUFFAGE OU DE REFROIDISSEMENT EN ALUMINIUM AFFICHÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.07.2015 DE 202015103786 U**
**17.07.2015 EP 15177392**

(43) Veröffentlichungstag der Anmeldung:
**30.05.2018 Patentblatt 2018/22**

(73) Patentinhaber: **Almeco GmbH**
**06406 Bernburg (DE)**

(72) Erfinder:
• **DASBACH, Reinhard**
**06406 Bernburg (DE)**
• **GLEICH, Rudi**
**33615 Bielefeld (DE)**

(74) Vertreter: **Strehl Schübel-Hopf & Partner**
**Maximilianstrasse 54**
**80538 München (DE)**

(56) Entgegenhaltungen:
WO-A1-2012/077687     GB-A- 2 382 871
GB-A- 2 483 484     JP-A- 2000 329 495
JP-A- 2015 036 596

## Beschreibung

Die vorliegende Erfindung betrifft ein Deckenelement, dessen dem Raum zugewandte Fläche farbig und/oder spiegelnd ausgeführt sein und eine Oberfläche mit unterschiedlichen Rauheitsgraden aufweisen kann. Das Deckenelement ist rückseitig so ausgestaltet, dass es besonders effektiv mit einem oder mehreren am Element angebrachten Rohren, in denen ein Wärmeträgermedium zirkuliert, verbunden werden kann, so dass es insbesondere als hocheffizientes Heiz- und/oder Kühldeckenelement genutzt werden kann.

Mit einer Kühl- bzw. Heizdecke soll Wärme aus Räumen innerhalb eines Gebäudes ab- bzw. eingeleitet werden, um diese Räume individuell zu klimatisieren. Daneben können noch weitere Funktionen wie zum Beispiel die Akustikgestaltung, der Brandschutz oder die Beleuchtung in die Deckenelemente integriert werden. Außerdem dienen die Deckenelemente auch der architektonischen Raumgestaltung, so dass neben den technischen Funktionen hohe ästhetische Ansprüche an die Deckenelemente gestellt werden.

Im Kühlmodus wird dabei die Wärme aus dem Raum durch Infrarotstrahlung oder durch thermische Konvektion zur Raumdecke transportiert. Dabei werden bis zu 2/3 der Wärme durch Infrarotstrahlung und der Rest hauptsächlich durch Konvektion transportiert. Daher ist es wichtig, dass eine Kühldecke Infrarotstrahlung möglichst gut absorbiert. Dies wird durch eine Oberfläche mit hoher thermischer Emission erreicht, da nach dem Kirchhoffschen Strahlungsgesetz dann auch eine hohe Absorption der Infrarotstrahlung erreicht wird. Bei Kühldecken mit hohem Strahlungsanteil liegt die empfundene Raumtemperatur um 1,5 - 2 K unterhalb der Raumlufttemperatur, was sich auf den Komfort positiv auswirkt. Nicht zuletzt gibt der Mensch seine überschüssige Wärme zu ca. 50 % durch Strahlung auf umliegende Flächen ab. Somit kommt ein Kühldeckensystem auf der Basis der Strahlungskühlung der physiologischen Wärmeabgabe des Menschen entgegen.

Im Heizmodus wird die über die Wärmeträgerflüssigkeit eingebrachte Wärme an das Deckenelement übertragen und hauptsächlich als Infrarotstrahlung an den Raum abgegeben. Daher ist auch in diesem Fall wichtig, dass die Oberfläche des Deckenelementes eine hohe thermische Emission besitzt, um eine hohe Abstrahlung von Infrarotstrahlung zu erreichen. Auch diese Wärmestrahlung wird von Menschen als besonders angenehm empfunden.

Aus dem Stand der Technik sind verschiedene Heiz- und Kühldeckenelemente bekannt. Deren Hauptelemente sind eine Deckenplatte und Rohrschlangen, die rückseitig, also auf ihrer dem Raum abgewandten Seite, an der Deckenplatte so befestigt sind, dass im Heizmodus möglichst viel Wärme aus einem in den Rohren zirkulierenden Heizmedium in die Deckenplatte und im Kühlmodus möglichst viel Wärme von der Deckenplatte in das dann als Kühlmedium fungierende Medium in den Rohren übertreten kann.

Als Deckenplatten werden hierbei häufig Gipskartonplatten eingesetzt, manchmal aber auch Metallplatten.

In DE 100 61 229 C1 wird eine aus Deckenplatten und einer Tragekonstruktion bestehende Raumdecke beschrieben, die von einem Heiz- oder Kühlmedium durchströmbare rohrförmige Kunststoffleitungen trägt, wobei die rohrförmigen Leitungen von einer dünnen, wärmeleitenden Kupferfolie umspannt sind, die mit der den Deckenplatten abgewandten Hälfte der rohrförmigen Leitungen in Kontakt steht und mit den Deckenplatten einen flächigen Kontakt bildet. Durch die um die Leitungen gelegte und auf die Deckenplatte gewalzte Kupferfolie erhält man große Kontaktflächen, die den Wärmewiderstand reduzieren.

Das in DE 298 03 663 U1 offenbarte Kühldeckenmodul besteht aus einem Verkleidungs-Deckenpaneel und einem Kühlsystem, welches aus auf der Innenseite des Deckenpaneels gehefteten Rohrschlagen besteht. Die Rohrschlangen sind mit einem Blech abgedeckt, welches eine das Rohr aufnehmende bzw. einfassende Sicke sowie sich seitlich davon erstreckende Flächenbereiche aufweist. Diese Flächenbereiche sind mit dem Deckenpaneel verklebt. Durch diese Konstruktion wird die durch das Deckenpanel aufgenommene Wärme flächig über das Blech aufgenommen und an die Rohre effektiv abgeführt.

Mit der Wärmeübertragung einer Strahlungsplatte beschäftigt sich JP 2505246 B2. Die Platte besteht aus rostfreiem Stahl, der mit einer durch Behandlung mit Chromschwefelsäure gewonnenen Oxidschicht bedeckt ist. Auf dieser Oxidschicht befindet sich eine Schicht aus einem Fluorharz (Polyvinylfluorid: PVF), die nur Strahlung mit einer Wellenlänge von 8-14 μm absorbiert. Über die Dicke der Oxidschicht wird die Farbe der Plattenoberfläche durch Interferenz eingestellt. Eine Verbesserung der Kühlungs- und Heizungsfunktionen gelingt gemäß JPS 6352296 (B2) dadurch, dass eine rückseitige Platte mit Ausnehmungen für Wasserrohre bereitgestellt wird, auf die auf der dem Raum abgewandten Seite ein wärmeisolierendes Material und auf der dem Raum zugewandten Seite eine Platte mit selektiv strahlender Oberflächenbeschichtung angebracht ist, die mit der Platte und den Wasserrohren in Kontakt steht. Die selektiv strahlende Oberflächenbeschichtung besteht aus einer zweilagigen Beschichtung, wobei die innere Schicht aus einer Schicht mit hoher Reflexion für sichtbare Strahlung, beispielsweise Aluminium, und die äußere Schicht aus einem Material besteht, das für sichtbares Licht lichtdurchlässig, für IR-Strahlung jedoch hochgradig absorbierend ist, beispielsweise aus Magnesiumoxid.

Aus WO 2011/128118 A1 ist es bekannt, Rohre eines flüssigkeitsführenden Rohrleitungssystems durch einen Ultraschall-Schweißvorgang mit einem Absorberblech eines Solarkollektors zu verbinden, ohne dass die wirksame Oberfläche des Solarkollektors beeinträchtigt wird. Hierfür wird ein Blech Omega-förmig um das Rohr gelegt und mit Hilfe zweier Sonotroden am Absorberblech angeschweißt.

In GB 2 382 871 A1 wird ein Heiz- und Kühlsystem für einen Eisenbahnwaggon beschrieben. Die GB 2 382 871 A1 offenbart dabei ein Deckenelement gemäß dem Oberbegriff von Anspruch 1.

Aus GB 2 483 484 A ist ein Deckenelement mit Wärmetauscher bekannt. Dieser kann eine thermisch wirksame Beschichtung aufweisen, um den Strahlungskühlungseffekt zu verbessern. Die Erfinder der vorliegenden Erfindung haben es sich zur Aufgabe gemacht, ein optisch ansprechend gestaltbares Deckenelement bereitzustellen, das dann, wenn es als Komponente eines Heiz- bzw. Kühldeckenelements für einen Raum, beispielsweise einen Wohn- oder Arbeitsraum, vorgesehen ist, diesem Heiz- bzw. Kühldeckenelement eine besondere Energieeffizienz verleiht.

Das Deckenelement soll dabei rückseitig eine geringe thermische Emission besitzen, und zwar vorzugsweise von weniger als 20%. Im Kühlmodus soll somit von der Gebäudehülle abgestrahlte Infrarotstrahlung an der dem Raum abgewandten Seite des Deckenelements reflektiert und damit ein unerwünschtes Aufheizen des Deckenelements unterdrückt werden. Im Heizmodus soll durch die geringe thermische Emission auf der dem Raum abgewandten Seite verhindert werden, dass Infrarotstrahlung in Richtung Gebäudehülle abgestrahlt wird.

Die Aufgabe wird erfindungsgemäß durch die Bereitstellung eines Deckenelements mit den Merkmalen von Anspruch 1 gelöst. Bevorzugte Ausführungsformen sind in den abhängigen Ansprüchen definiert.

Werden Platten aus Aluminium oder einer Aluminiumlegierung eingesetzt, lässt sich in einer ersten Ausführungsform der Erfindung die erforderliche zum Raum hin gerichtete thermische Emission durch das Aufbringen einer Aluminiumoxidschicht mit einer Dicke von mindestens 1 $\mu$m auf die Platte bewirken, wobei sich diese Schicht durch Anodisierung der Aluminiumoberfläche erzeugen lässt. Dabei können Platten mit verschiedenen Ausgangsrauigkeiten (z.B. mit einer $R_a$ von 10 nm bis 2 $\mu$m) verwendet werden, um Oberflächen mit unterschiedlichem diffusem Reflexionsanteil (zwischen 5% und 95% nach DIN 5036-3) zu erhalten. So kann man die Oberflächenerscheinung für die Raumgestaltung von spiegelnd bis matt einstellen. Werden zusätzlich noch Leuchtkörper in die Deckenelemente integriert, so kann zusätzlich die Lichtverteilung im Raum gesteuert werden.

Das Aluminium wird vor dem Anodisieren elektrochemisch poliert. Dabei kann durch die Prozessparameter (Stromstärke, Badtemperatur etc.) gesteuert werden, ob eine hohe Totalreflexion mit geringem diffusem Reflexionsanteil oder ein hoher diffuser Reflexionsanteil erzielt wird.

Normalerweise besitzt ein guter Aluminiumspiegel eine hohe Reflexion auch im Bereich der thermischen Infrarotstrahlung. Durch Aufbringen einer Anodisierungschicht von mindestens 1 $\mu$m (z.B. von etwa 4 $\mu$m) auf der erfindungsgemäß verwendeten Aluminiumplatte bleibt die hohe Reflexion (Totalreflexion >75% nach DIN 5036-3) im sichtbaren Bereich erhalten, im InfrarotBereich wird die Reflexion durch diese Maßnahme jedoch beträchtlich abgesenkt, so dass das Material die nötige hohe Emission (im Beispiel: >70%) erhält, um im Kühlmodus möglichst gut Infrarotstrahlung aus dem Raum zu absorbieren und auf der anderen Seite im Heizmodus möglichst gut Infrarotstrahlung an den Raum abzugeben. Damit erhält man eine selektive Beschichtung mit hoher thermischer Emission im Infraroten und hoher Reflexion im sichtbaren Wellenlängenbereich. Durch diesen synergetischen Effekt können Deckenelemente mit metallisch spiegelnder Oberfläche hergestellt werden, die gleichzeitig eine hohe thermische Emission besitzen. Damit kann ein Deckenelement für architektonische Gestaltung mit hohen ästhetischem Erscheinungsbild geschaffen werden.

In einer Ausführungsform der Erfindung wird daher ein Deckenelement mit einer Totalreflexion nach DIN 5036-3 von mindestens 70% und besonders bevorzugt von mindestens 80% bereitgestellt.

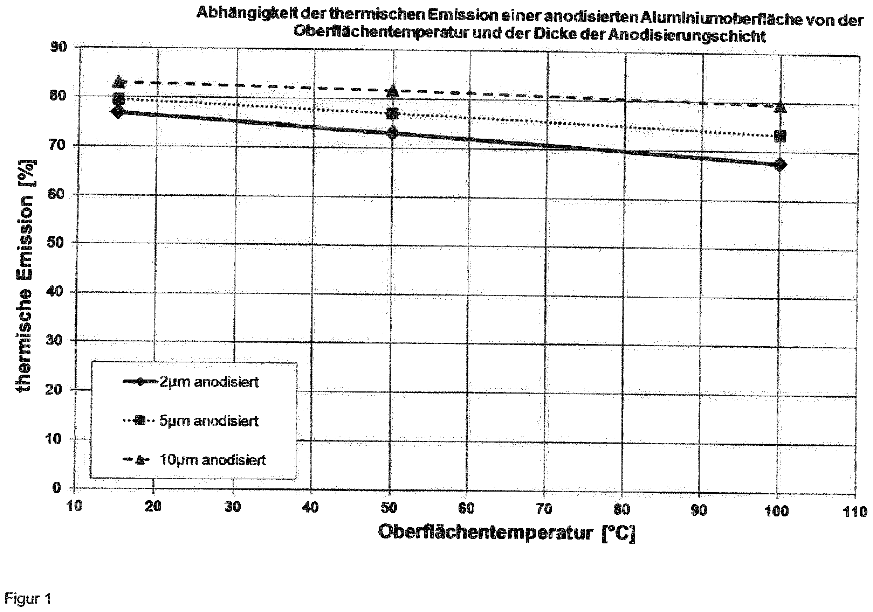

Die Dicke der Anodisierungsschicht kann in bevorzugter Weise im Bereich zwischen 1 und 10 $\mu$m besonders bevorzugt zwischen 2 und 6 $\mu$m gewählt werden. Sie beeinflusst den Anteil der thermischen Emission, die mit steigender Dicke der Schicht zunimmt. In Figur 1 ist die Abhängigkeit der Emission von der Dicke einer durch Anodisierung gebildeten Aluminiumoxidschicht bei verschiedenen Oberflächentemperaturen der beschichteten Platte gezeigt. So steigt die thermische Emission einer ca. 50°C heißen Plattenoberfläche von ca. 73% bei 2 $\mu$m Dicke auf ca. 82% bei 10 $\mu$m Dicke.

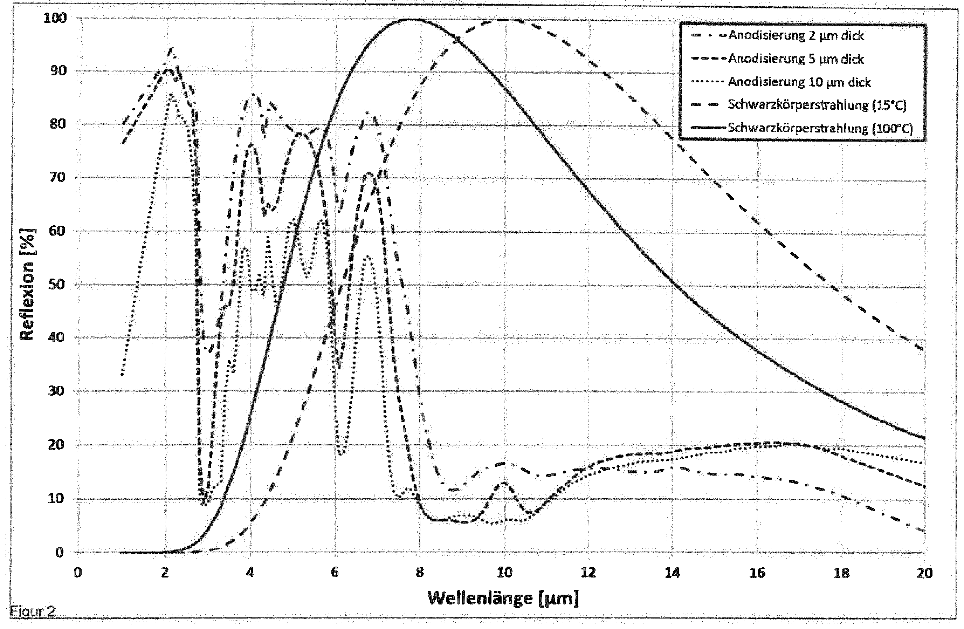

Bei Verwendung dieses Deckenelements aus Aluminium oder einer Aluminiumlegierung als zum Raum gerichtete Komponente einer Heiz- bzw. Kühldecke eines Raumes wird eine besonders hohe Energieeffizienz erreicht, weil die anodisierte Oberfläche im Bereich der thermischen Infrarotstrahlung (2,0 bis 50 $\mu$m) eine integral geringe Reflexion besitzt (siehe Figur 2) und nach dem Kirchhoffschen Gesetz und unter der Berücksichtigung der Energieerhaltung in diesem Wellenlängenbereich somit eine besonders hohe thermische Emission (nach ISO 22975-3:2014; Annex A.2) aufweist.

In Figur 2 ist die Reflexion von Aluminium mit verschiedenen Anodisierungsdicken aufgetragen. Daneben ist die Emission eines schwarzen Strahlers bei 15°C und 100°C in a. u. (arbitrary units, frei gewählten Einheiten) aufgetragen. Daraus ist zu erkennen, dass die Reflexion der anodisierten Aluminiumoberfläche im Bereich des Maximums der Emissionskurve besonders klein ist, was in einer hohen thermischen Emission resultiert.

Die außenliegende Oberfläche des erfindungsgemäßen Deckenelements besitzt darüber hinaus den Vorteil, dass sich anodisierte Aluminiumoberflächen mit farbigen Pigmenten versetzen lassen, wodurch man farbige Oberflächen erhält. Somit erhält man eine selektiv beschichtete Oberfläche, die je nach Wunsch farbig gestaltet werden kann und gleichzeitig eine hohe thermische Emission besitzt. Auch hier führt dieser synergetische Effekt zu einem Deckenelement mit hohem ästhetischem Anspruch für architektonische Anwendungen.

Dazu wird die Aluminiumoberfläche zunächst chemisch mit Lauge, üblicherweise in einer kaustischen, stark alkalischen Lauge entfettet und geätzt, um die natürliche Aluminiumoxidschicht von etwa 10nm Dicke zu entfernen. Danach folgt ein elektrochemisches Polieren und anschließend das elektrochemische Anodisieren in verdünnter Schwefelsäure. In dem Bad wird das zu anodisierende Blech als Anode geschaltet und eine Gleichspannung von üblicherweise etwa 5 - 50V angelegt.

Die Kathode ist üblicherweise aus Blei ausgebildet. In dem so entstandenen Spannungsfeld wandern sauerstoffhaltige Anionen zur Aluminiumoberfläche. Dort reagieren sie mit der Aluminiumoberfläche, und es bildet sich Aluminiumoxid, das aufgrund seines größeren Volumens aus der ursprünglichen Metalloberfläche herauswächst, aber mit dem Aluminium fest verbunden bleibt. Dabei entstehen kapillarähnliche Poren im Aluminiumoxid mit einem Durchmesser von in der Regel 10 nm bis 50 nm. In diese Poren können nun anorganische oder organische Pigmente eingebracht werden, indem das Band durch ein Bad mit einer Lösung, die Pigmente mit einer definierten Konzentration enthält, gezogen wird. Als anorganisches Pigment wird zum Beispiel Eisenoxalat und als organische Pigmente werden bevorzugt Azopigmente eingesetzt. Als Azopigmente bezeichnet man organische Pigmente, die eine oder mehrere Azogruppen -N=N- enthalten. Die Farbintensität wird dabei neben der Konzentration der Pigmente auch von der Dicke der Anodisierungsschicht bestimmt. Je dicker die Anodisierungsschicht ist, desto mehr Pigmente können eingelagert werden und desto intensiver ist der Farbeindruck. Nach dem Einbringen der Pigmente werden die Poren im Aluminiumoxid in heißem Wasser versiegelt, so dass die Farbstoffe dauerhaft in die Aluminiumoxidschicht eingebettet werden.

Ein weiterer Vorteil der dicken Anodisierungschicht besteht darin, dass die Oberfläche durch das harte Aluminiumoxid sehr kratzfest wird, so dass sämtliche dekorativen Applikationen auf der Oberfläche gut gegen mechanische Beschädigung geschützt sind.

In einer zweiten Ausführungsform der Erfindung, die sich mit allen einsetzbaren Metallplatten realisieren lässt, wird die zum Raum gerichtete Seite der Metallplatte mit einer stöchiometrischen oder unterstöchiometrischen Siliciumoxid-Beschichtung, die mit Hilfe des Sol-Gel-Verfahrens aufgebracht wird, und/oder mit einem Fluoropolymerlack von jeweils mindestens 2 μm Dicke überzogen. Werden in dieser Ausführungsform Platten aus Aluminium oder einer Aluminiumlegierung verwendet, kann diese Seite anodisiert sein, muss es aber nicht.

Der Vorteil dieser zwei Beschichtungssysteme besteht darin, dass diese im sichtbaren Bereich transparent sind, während sie im infraroten Wellenlängenbereich Absorptionsbanden aufweisen, die in einer hohen thermischen Emission resultieren. Somit ist es auch mit diesen Schichtsystemen möglich, eine selektive Beschichtung mit hoher thermischer Emission im Infraroten und hoher Reflexion im sichtbaren Wellenlängenbereich zu erzeugen. Durch diesen synergetischen Effekt können auch damit Deckenelemente mit metallisch spiegelnder Oberfläche hergestellt werden, die gleichzeitig eine hohe thermische Emission besitzen. Damit kann ein Deckenelement für architektonische Gestaltung mit hohen ästhetischem Erscheinungsbild geschaffen werden.

Die thermische Emission der metallisch sauberen Oberflächen von Aluminium, Stahl, Weißblech und Edelstahl ist abhängig von der Oberflächengüte. Bei einer polierten Oberfläche liegt die thermische Emission unter 10%, bei einer typischen gewalzten Oberfläche (mill finish) unter 15% und selbst bei einer sandgestrahlten Oberfläche noch unter 40%. Damit sind diese Materialien für Kühl- und Heizdeckenelemente erst einmal schlecht geeignet. Erfindungsgemäß konnte jedoch festgestellt werden, dass sich die thermische Emission bei 100°C Oberflächentemperatur nach ISO 22975-3:2014; Annex A.2 durch die Beschichtung mit den vorgenannten Materialien auf über 50% steigern lässt.

Fluoropolymerlacke sind polymere Fluorkohlenwasserstoffe und enthalten Kohlenstoffketten mit perfluorierten Kohlenstoffatomen. Für die Zwecke der Erfindung eignen sich dem Grunde nach alle polymeren fluorierten Kohlenwasserstoffe, wobei jedoch solche Polymere besonders bevorzugt sind, die mit drei Fluoratomen substituierte Ethyleneinheiten aufweisen. Diese besitzen hydrophobe Eigenschaften, die für die Erfindung besonders geeignet sind. Sie sind einerseits aufgrund ihrer höheren Substitution mit Fluor gegenüber z.B. Polyvinylidenfluorid (mit zwei Fluoratomen pro Ethyleneinheit) bevorzugt, sind aber auch günstiger als vollständig perfluorierte Materialien wie Teflon. Besonders günstig für die Erfindung ist die Verwendung von vernetzten oder unvernetzten Fluorethylenvinylether-Harzen wie Lumiflon®, weil die Prepolymere gute Löslichkeitseigenschaften aufweisen und die fertigen Lacke eine hohe Transparenz und Flexibilität zeigen. Eine Vernetzung erfolgt dabei üblicherweise durch die Einpolymerisierung von Isocyanat-Gruppen, wodurch vernetzte Fluorurethan-Lacke entstehen.

Sol-Gel-Lacke werden durch hydrolytische Kondensation geeigneter Silane oder Polysiloxane in einem geeigneten Lösungsmittel erzeugt. Im Lösungsmittel entsteht dabei ein Gel mit einem bereits weitreichenden Netzwerk, so dass nach Aufbringen des Harzes oder Lacks und Entfernen des Lösungsmittels durch Ausheizen oder dergleichen eine stark vernetzte dreidimensionale $SiO_x$-Schicht entsteht.

Die erfindungsgemäß einsetzbaren Materialien verleihen nicht nur die gewünschten thermischen Emissionseigenschaften; der zusätzliche Vorteil dieser Beschichtungen liegt darin, dass die Oberfläche gut gegen Umwelteinflüsse wie Feuchtigkeit und korrosiven Angriff geschützt wird. Dies ist besonders wichtig bei der Verwendung von Stahl. Daneben ist eine durch das Sol-Gel-Verfahren erzeugte $SiO_x$-Beschichtung auch sehr hart, so dass die Oberfläche vor mechanischer Beschädigung geschützt wird. Fluoropolymerlack bietet den zusätzlichen Vorteil, dass die Oberfläche hydrophobe Eigenschaften aufweist, so dass Schmutz gut abgewiesen wird.

Beide Beschichtungen bieten den Vorteil, dass sie leicht in einer industriellen Bandbeschichtungsanlage auf nur einer Seite des Blechs aufgetragen werden können. In jedem Fall wird das Substrat, also die Metallplatte, beidseitig vor der Beschichtung vorzugsweise technisch entfettet, um eine gute Haftung der Beschichtung und später eine gute Ultraschall-Schweißbarkeit zu gewährleisten.

Um die Oberfläche zusätzlich noch farbig zu gestalten, kann die Metalloberfläche vor der Beschichtung mit einer Sol-Gel-SiO$_x$ Beschichtung oder einem Fluoropolymerlack noch mittels einer PVD-Beschichtung, z.B. auf einer industriellen PVD Bandbeschichtungsanlage, mit einer farbigen Schicht beschichtet werden.

Somit erhält man auch damit eine selektiv beschichtete Oberfläche, die je nach Wunsch farbig gestaltet werden kann und gleichzeitig eine hohe thermische Emission besitzt. Auch hier führt dieser synergetische Effekt zu einem Deckenelement mit hohem ästhetischem Anspruch für architektonische Anwendungen.

Weiterhin können eine Haftschicht, die die Haftung der farbigen Schicht auf der Metalloberfläche verbessert, und/oder eine Haftschicht, die die Haftung zur später aufzubringenden Sol-Gel-SiO$_x$-Schicht oder des Fluoropolymerlacks verbessert, aufgebracht werden. In der Regel sind weitere Schichten nicht vorhanden; dies ist aber nicht zwingend. So kann die zum Raum hin weisende Oberfläche des Deckenelements bei Bedarf mit einem zusätzlichen Lack versehen werden, beispielsweise für Schutz- oder Dekorationszwecke.

Dieser Lack wird vorzugsweise als abschließende Schicht aufgetragen. Hierfür eignen sich beliebige Lacke, darunter, um nur ein Beispiel zu nennen, Pulverlacke.

Die nachstehenden Schichtsysteme aus folgenden Schichten haben sich bewährt:

1. Schicht unmittelbar auf der Metalloberfläche (optional)

Haftschicht aus Cr, Ti, Al oder einer Nickellegierung, besonders bevorzugt NiV, NiCr oder NiAl. Besonders bevorzugt wird dieser Schicht aufgesputtert.

2. Schicht unmittelbar auf der Metalloberfläche oder unmittelbar auf der Haftschicht

Schicht aus Si, SiO$_x$N$_y$, TiO$_x$N$_y$C$_z$, TiAl$_s$N$_y$O$_x$ oder CrO$_x$N$_y$C$_z$ oder ZrO$_x$N$_y$C$_z$, worin x, y und z so gewählt sind, das die Verbindungen unterstöchiometrisch bezüglich der Summe der Anionen und insbesondere bezüglich des Sauerstoffs sind, wobei x>0 sein muss, während y und z jeweils $\geq$0 sind. Es ist bevorzugt, wenn es sich bei den Verbindungen um reine Oxide oder um Oxynitride handelt; das Vorhandensein von Kohlenstoff ist möglich, aber nicht zwingend. Der Wert von s liegt im Bereich von 20 bis 80 Atom-%, bezogen auf das vorhandene Titan.

Hierzu ist es vorteilhaft, die Schicht reaktiv zu sputtern. Dabei werden Gase über Massendurchflussregler (Mass flow controller, MFC) definiert in die Sputterkammer zusätzlich zum Arbeitsgas (bevorzugt Argon) eingelassen. Daneben ist es besonders vorteilhaft, den Sauerstoffgehalt über eine Lambdasonde oder einen Plasmamonitor definiert zu steuern. Als Gase eignen sich bevorzugt Sauerstoff, Stickstoff und kohlenstoffhaltige Gase wie zum Beispiel Methan, Ethin oder Kohlendioxid.

Die Farbe kann hierbei über die Schichtdicke und die Zusammensetzung der Schichten eingestellt werden. Es können z. B. Farbtöne rot, orange, grün, blau, lila, gold, grau oder anthrazit eingestellt werden.

3. Schicht Haftschicht für die Sol-Gel- oder Fluropolymerlack Beschichtung (optional)

Schicht aus gesputtertem SiO$_x$, ZrO$_x$, TiO$_x$ oder ZAO (Aluminium dotiertes Zinkoxid). Dicke im Bereich von vorzugsweise 2 - 100 nm.

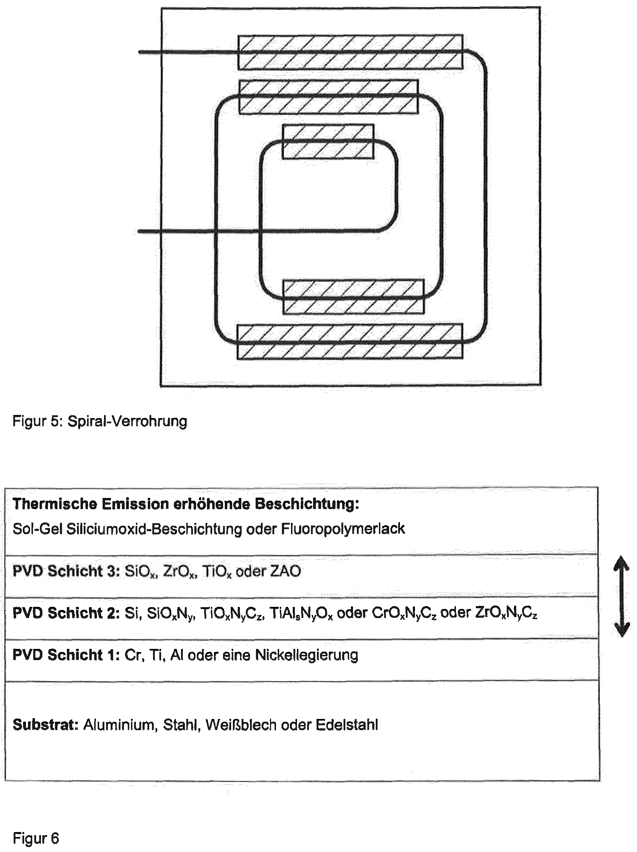

Ein Schichtsystem mit allen dreien dieser möglichen PVD-Schichten ist in Figur 6 gezeigt; siehe den Pfeil am Rande der Grafik in Verbindung mit den Schichten "PVD Schicht 1" bis "PVD Schicht 3". Dabei wird die Färbung durch die einzig vorhandene 2. Schicht oder aber durch das synergetische Zusammenwirken aller Schichten bestimmt.

Die erfindungsgemäß eingesetzte Metallplatte hat in der Regel eine Dicke von 0,1 bis 3 mm, kann bei Bedarf aber auch dicker oder dünner sein. Die Platte wird im vorliegenden Text in manchen Fällen auch als Blech bezeichnet, ohne dass hierdurch ein Unterschied aufgezeigt werden soll. Sie kann regelmäßig oder in einem gewünschten Muster Vertiefungen oder durchgehende Öffnungen enthalten, beispielsweise Lochungen oder Schlitze, die durch einen Laser oder durch Stanzen eingebracht werden können. Diese Maßnahme verbessert das Schallschluckverhalten. Um das Schallschluckverhalten noch weiter zu verbessern, kann auf der Rückseite des Deckenelementes zusätzlich ein schallschluckendes Material (z. B. ein Vlies) angebracht werden.

Durch Dessinieren mit einer Prägewalze, selektives Ätzen der Oberfläche oder durch Bearbeitung mit einem Laser können Muster für dekorative Zwecke auf der Metalloberfläche erzeugt werden. Z. B. können auch Kundenlogos oder Schriftzüge realisiert werden. In diesem Fall wird das Material bevorzugt nach Einbringen der Musterung ggf. elektrochemisch poliert und entweder anschließend beschichtet oder, nur im Fall von Aluminium oder einer Aluminiumlegierung, anodisiert.

Die geringe thermische Emission der dem Raum abgewandten Seite des Deckenelementes von bevorzugt weniger als 20% wird dadurch erreicht, dass diese Oberfläche metallisch ausgestaltet wird, mit Ausnahme einer möglichen natürlichen Oxidhaut im Falle von Platten aus Aluminium und/oder einer Aluminiumlegierung. D. h. in dem Fall, dass das Deckenelement aus anodisiertem Aluminium gefertigt wird, muss die Anodisierungsschicht, die prozessbedingt auf beiden Seiten des Blechs aufwächst, auf der dem Raum abgewandte Seite nach der Anodisierung wieder entfernt werden.

Im Heizmodus wird durch die geringe thermische Emission auf der dem Raum abgewandten Seite verhindert, dass Infrarotstrahlung in Richtung Gebäudehülle abgestrahlt wird. Somit kann durch das erfindungsgemäße Deckenelement gezielt Infrarotstrahlung hauptsächlich in den Innenraum abgestrahlt werden.

Um auch eine hohe Energieeffizienz bei der Weiterleitung der Wärme aus oder in das auf der Rückseite des Deckenelements befindliche Rohrleitungssystem zu erzielen, welches mit einer Wärmeträgerflüssigkeit durchströmt wird und zusammen mit dem erfindungsgemäßen Deckenelement unter Ausbildung einer Kühl- oder Heizdecke kombiniert werden soll, sollte die Ableitung der Wärme aus dem Raum, die durch thermische Infrarotstrahlung und durch thermische Konvektion in das Raumdeckenelement eingetragen wird, möglichst effizient durch das Rohrleitungssystem abtransportiert werden können. Wird im umgekehrten Fall das Deckenelement als Heizelement betrieben, muss die Wärme aus dem Rohrsystem möglichst effizient an das Deckenelement abgegeben werden.

Eine wichtige Kenngröße für die Leistung eines Heiz- bzw. Kühldeckenelementes ist der thermische Widerstandswert R [$m^2K/kW$] = $F\Delta T/\dot{Q}$. Dieser ist ein Maß für den Wärmetransport zwischen Wärmeträger führendem Rohr und der zum Raum gerichteten Oberfläche F des Deckenelementes. Er gibt an, welche Temperaturdifferenz $\Delta T$ nötig ist, um eine bestimmte Wärmemenge $Q$ durch eine Fläche $F$ des Oberflächenelementes zu transportieren. Der Widerstandswert R sollte möglichst klein sein. Dazu ist es vorteilhaft, wenn die Rohre so an das Deckenelement angebracht werden, dass die Wärmeleitung zwischen den Rohren und dem Deckenelement möglichst hoch ist, dass also der Wärmewiderstand möglichst gering ist.

Erfindungsgemäß ist vorgesehen, die Rohre zu diesem Zweck an das Deckenelement anzufügen, wobei das Fügeverfahren jedoch so ausgestaltet sein muss, dass beim Fügen die zum Raum gerichtete Oberfläche, die hohen ästhetischen Anforderungen genügen muss, nicht beschädigt wird. Als Fügeverfahren, die eine gute Wärmeleitung gewährleisten, haben sich in der Vergangenheit das Laserschweißen und das Ultraschallschweißen bewährt. Diese Verfahren können selbstverständlich eingesetzt werden. Beide Verfahren können unter Umständen jedoch die dem Raum zugewandte Oberfläche beschädigen. In solchen Fällen lässt sich dieser Nachteil umgehen, indem das Ultraschall-Schweißverfahren mit Hilfe von mindestens zwei Sonotroden wie in WO 2011/128118 A1 durchgeführt wird, wobei Fügestreifen formschlüssig um das oder die auf der Rückseite des Deckenelements aufgelegte(n) Rohr(e) gelegt und an die Rückseite des Deckenelements angeschweißt werden. Dabei wird einerseits die dem Raum zugewandte Fläche nicht beschädigt und zum anderen ein guter Wärmeübergang erzielt, weil unter der Einwirkung des Ultraschalls eine plastische Verformung der Metallteile stattfindet, deren Oberflächen dadurch eine intensive Verbindung miteinander eingehen. Durch Verwendung einer dritten Sonotrode wie in WO 2011/128118 A1 beschrieben, mit der die Fügestreifen auf der dem Deckenelement abgewandten Seite des oder der Rohre an diese angeschweißt werden, kann der Wärmeübergang sogar noch gesteigert werden. Diese zusätzliche Schweißnaht ist optional.

Die Rohre können aus einem beliebigen, geeigneten Material bestehen, beispielsweise aus einem Metall wie Aluminium, einer Aluminiumlegierung, Kupfer, einer Kupferlegierung, Messing, Edelstahl, Kunststoff und einem Komposit, wobei der Komposit aus einem Kunststoff und einem Metall oder aus zwei verschiedenen Metallen bestehen kann. Für die zusätzliche Schweißverbindung zwischen Fügestreifen und Rohr mittels der genannten dritten Sonotrode ist es günstig, wenn auch nicht zwingend, wenn die Rohre aus Metall bestehen. Wenn sie aus Metall bestehen, sollten sie generell metallisch "blank" sein, um eine gute Wärmeleitung zu erreichen. Dies gilt insbesondere dann, wenn es vorgesehen ist, dass der Rücken des Rohres mithilfe einer dritten Sonotrode mit dem oder den Fügestreifen verschweißt werden soll. Die Dicke der Rohre und deren Durchmesser kann je nach Bedarf gewählt werden. Geeignet sind beispielsweise Rohre mit Durchmessern von ca. 6-12 mm. Die Rohre werden in einem beliebigen Muster in einem geeigneten, möglichst gleichbleibenden Abstand zueinander (z.B. 80 - 120 mm) verlegt.

In einer speziellen Ausgestaltung mit nochmals verbesserter Wärmeeffizienz werden die Rohre auf die Rückseite des Deckenelements derart aufgepresst, dass sie sich verformen und dabei unter zunehmender Kontaktfläche mit dem Deckenelement flacher werden. Diese Maßnahme kann durchgeführt werden, bis die Rohre einen annähernd halbrunden Querschnitt angenommen haben, dessen Basisfläche an der Rückseite des Deckenelements anliegt, während sich die Rundung in der vom Deckenelement abgewandte Richtung erstreckt. Durch die hierbei gewonnene zusätzliche Kontaktfläche wird der Wärmefluss stark verbessert. Zum Verformen der Rohre werden diese vorzugsweise während des Schweißvorgangs mittels einer Anpressrolle angedrückt.

Erfindungsgemäß ist es vorgesehen, die Verbindung zwischen dem Fügestreifen und der Rückseite des Deckenelements besonders kraftschlüssig zu gestalten. Dies gelingt, weil die Rückseite der Metallplatte des Deckenelements keinerlei technisch aufgebrachte Beschichtung aufweist, sondern aus der "blanken" Metalloberfläche (d.h. auch im Falle von Aluminium aus der "blanken" Aluminiumoberfläche) als solcher besteht, wie sie unter natürlicher Umgebungsatmosphäre existiert. Aluminium bildet unter Umgebungsatmosphäre eine natürliche Oxidhaut (in der Regel von etwa 10nm Dicke) aus. Das bedeutet, dass die Aluminiumoberfläche erfindungsgemäß auf dieser Seite keine Anodisierungsschicht aufweist.

Somit ist gewährleistet, dass in allen Ausgestaltungen der Erfindung die Rückseite der Platte bzw. des Bleches metallisch bleibt und somit mittels des beschriebenen Ultraschallschweißverfahrens gut Rohre unter Verwendung eines Fügestreifens aufgeschweißt werden können.

Während eine "blanke" Oberfläche bei Materialien wie Stahl, Weißblech oder Edelstahl ohne weiteres erzeugt bzw. beibehalten werden kann, lässt sich diese "blanke" Oberfläche im Falle von Aluminium oder einer Aluminiumlegierung durch eine besondere Prozessführung nach der Anodisierung des Aluminiumbleches erzielen: Während des Anodisierungsvorgangs werden normalerweise beide Seiten des Aluminiumbleches mit einer Anodisierungsschicht überzogen wie oben beschrieben. Um die Anodisierungsschicht nur auf der Rückseite zu entfernen, wird die Oberfläche mit einer handelsüblichen selbstklebenden Schutzfolie (besonders bevorzugt aus Polyethylen mit einer gummibasierten Klebeschicht) geschützt und das Aluminiumband durch heiße kaustische Lauge gezogen. Dabei wird auf der ungeschützten Seite des Aluminiumbandes die Anodisierungsschicht weggeätzt. Anschließend wird das Band im Wasserbad gespült und getrocknet. Vorzugsweise verbleibt die Schutzfolie auf der Oberseite bis zur Montage des Deckenelementes. Dieser Schritt wie auch die vorherige Anodisierung erfolgt vorzugsweise in einer Bandanlage; erst das fertig beschichtete bzw. von der Beschichtung befreite Aluminiumblech wird dann in der Regel in geeignete Platten geschnitten, deren Größe natürlich nach Bedarf variieren kann.

Die natürliche Oxidhaut wird ohne weiteres durch den Ultraschallschweißvorgang weggerieben, so dass eine kraftschlüssige Verbindung zwischen der Metalloberfläche der Metallplatte und der Metalloberfläche des Fügestreifens durch den Ultraschallschweißvorgang gebildet wird.

Im Falle von Aluminium oder einer Aluminiumlegierung als Metall der für das Deckenelement verwendeten Platte bestehen die Fügestreifen vorzugsweise ebenfalls aus "blankem", d.h. nicht anodisiertem Aluminium (vorzugsweise reinem Aluminium, z.B. A1050 oder besser) oder einer Aluminiumlegierung. Stattdessen können sie aber auch aus einem anderen Metall oder einer anderen Metall-Legierung wie Kupfer, Stahl oder Edelstahl bestehen. In dem Fall, dass Stahl, Weißblech oder Edelstahl für das Deckenelement verwendet wird, ist es vorteilhaft, dass der Fügestreifen aus Stahl, Weißblech oder Edelstahl besteht. Kupfer eignet sich ebenfalls hervorragend und bietet darüber noch den Vorteil einer höheren Wärmeleitfähigkeit gegenüber den Stahlwerkstoffen.

An der Rückseite des Deckenelementes können Befestigungselemente angebracht werden, mit denen sich die Deckenelemente an der Raumdecke aufhängen lassen. Die Befestigungselemente können aufgeklebt oder besonders bevorzugt durch Ultraschallschweißen befestigt werden. In diesem Fall bestehen die Befestigungselemente vorzugsweise aus Aluminium oder Aluminiumlegierungen oder aus Stahl.

In einer besonderen Ausgestaltung der Erfindung besitzt das Deckenelement Aussparungen, in denen sich Leuchtmittel befinden. Bevorzug werden diese durch Laserschneiden eingebracht. Durch die hohe Reflexion des Materials im sichtbaren Bereich kann eine hohe Lichtausbeute oder im Falle einer eingefärbten Oberfläche ein gewünschter Farbeindruck erzielt werden. Im Falle von LED-Leuchtmitteln können diese besonders effizient gekühlt werden, so dass eine hohe Lichtausbeute gewährleistet ist (die Lichtausbeute sinkt bei LEDs mit der Betriebstemperatur). Natürlich lassen sich weitere Komponenten in das Deckenelement integrieren, beispielsweise Lautsprecherboxen, Feuersensoren, Sprinkleranlagen etc.

Nachstehend wird die Erfindung anhand von Ausführungsbeispielen näher erläutert.

**A. Herstellung eines erfindungsgemäßen Aluminiumblechs**

Für die elektrochemische Behandlung des Aluminiumblechs wird eine kommerziell verfügbare Bandanodisierungsanlage mit Pigmentierungseinheit benutzt. D. h. es werden AluminiumBänder in einem kontinuierlichen Verfahren behandelt, bei dem das Band unterschiedliche Bäder durchläuft.

**Schritt 1:**

Kaustisches Ätzen in einer starken alkalischen Lauge, um von der Aluminiumoberfläche Rückstände aus dem Walzprozess des Aluminiums (Öle, Fette, Walzemulsion) und die natürliche Aluminiumoxidhaut von etwa 10nm zu entfernen, um eine metallisch reine Oberfläche zu erhalten.

**Schritt 2:**

elektrochemisches Polieren der Oberfläche in einer Mischung aus Phosphor- und Schwefelsäure. Dabei wird durch Anlegen einer elektrischen Spannung von 10 - 60V vorwiegend an den aus der Oberfläche herausragenden Aluminiumerhöhungen (Walzriefen) durch Feldüberhöhung eine Aluminiumoxidschicht erzeugt. D. h. besonders die Unebenheiten werden in Aluminiumoxid umgewandelt.

**Schritt 3:**

Abätzen dieser Aluminiumoxidschicht in kaustischer Lauge, so dass vorwiegend die Unebenheiten abgetragen werden.

**Schritt 4:**

Elektrochemisches Anodisieren der Oberfläche in verdünnter Schwefelsäure unter Anlegen einer elektrischen Spannung von 5 - 50V.

**Schritt 5:**

Optional: Pigmentieren. Einbringung von Farbpigmenten in die Poren des Aluminiumoxids.

**Schritt 6:**

Versiegeln der Poren des Aluminiumoxides in heißem Wasser mit chemischen Zusätzen durch Bildung von Aluminiumhydroxid.

**Schritt 7:**

Trocknen, Aufspulen.

**Schritt 8:**

Aufbringen einer selbstklebenden Polyethylen Schutzfolie auf der Seite, die später dem Raum zugewandt ist.

**Schritt 9:**

Erneutes Durchlaufen der Bandanodisierungsanlage. Hierbei wird nur der Tank zum Ätzen genutzt, um die Anodisierungschicht auf der nicht durch die Folie geschützten Rückseite in heißer kaustischer Lauge zu entfernen.

**Schritt 10**

Spülen in deionisiertem Wasser, Trocknen, Aufspulen

**Schritt 11**

Richten und Schneiden des Aluminiumbands in Platten, beispielsweise in einer Größe von 1,25 m x 2,00 m.

**B. Erzeugen eines Wärme- und/oder Kühldeckenelements mit dem Aluminiumblech gemäß A.**

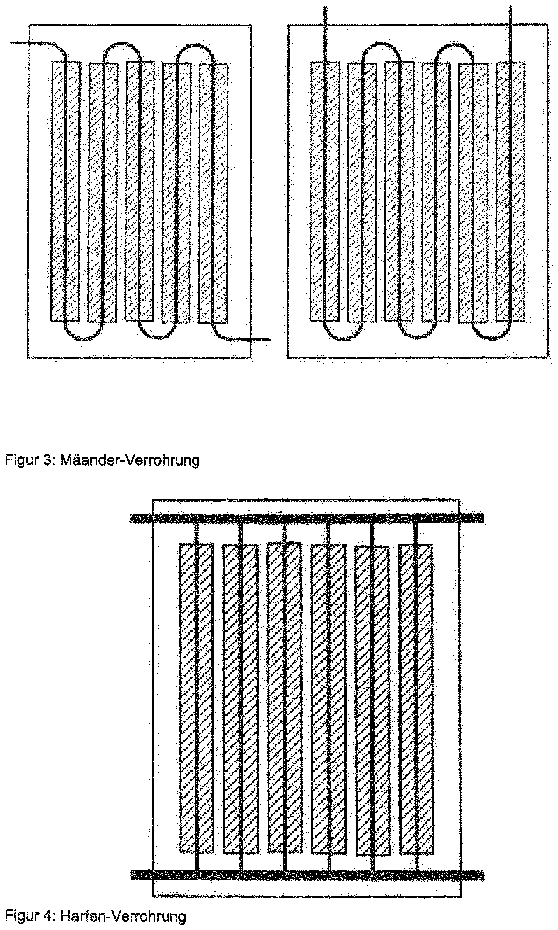

Im nächsten Schritt werden Kupfer-Rohre mit einem Durchmesser von 10 mm und Standard-Dicke auf die Rückseite des Deckenelements aufgelegt und mit Hilfe einer Ultraschallschweißmaschine mit zwei Sonotroden mit Aluminiumblechen verschweißt, derart, dass die beiden Sonotroden parallel verlaufende Laufbahnen besitzen. Eine dritte Sonotrode verschweißt die Aluminiumbleche mit dem Rücken des Rohres. Mögliche, mäanderförmige Rohrverläufe sind in Figur 3 gezeigt, weitere, alternative Rohrverläufe in Figur 4 und Figur 5. Dabei sind die Rohrleitungen jeweils ca. 100 mm (lichte Weite) voneinander beabstandet. Die Rohrenden ragen auf einer Seite der Platte über diese hinaus und besitzen geeignete Anschlussmittel, beispielsweise ein außenliegendes Schraubgewinde oder einen Schnellverschluss. Die Position der Anschlüsse und die Anschlusselemente sind so gewählt, dass mehrere Deckenelemente leicht zusammengekoppelt werden können. Bevorzugt werden für die Verbindung flexible Schläuche aus Kunststoff und/oder Metall verwendet.

Die Vermessung der Leistung von Kühldecken wird in der DIN EN 14240 beschrieben: Dabei wird das Kühldeckenelement oder mehrere identische Kühldeckenelemente in einen Messraum verbracht, dessen Umschließungsflächen auf die Raumtemperatur im Prüfraum temperiert werden zur Vermeidung von Wärmeverlusten bzw. Wärmeeinträgen (Raumtemperatur bei Prüfung: 22...27°C) durch die Außenwände. Im Messraum befinden sich Kühllastsimulatoren - elektrisch beheizte Heizkörper -, die eine definierte Kühllast einbringen. Die Raumtemperatur $T_{Globe}$ wird dabei mit einem "Globe-Thermometer" bestimmt. Die Kühldeckenelemente werden mit Wasser mit definiertem Fluss und definierter Temperatur ($T_{VL}$ ist dabei die Vorlauf- und $T_{RL}$ die Rücklauftemperatur des Wassers) durchströmt, so dass sich eine "Untertemperatur" $T_U$ zur Raumtemperatur einstellt.

Die "Untertemperatur" ist definiert durch:

$$\Delta T_U = T_{Globe} - \frac{T_{VL} - T_{RL}}{2}$$

Danach wird ein thermischen Gleichgewichts zwischen Kühllastsimulatoren und Kühlfläche eingestellt und die Heizleistung der Kühllastsimulatoren gemessen. Diese ist mit der Wärmeleistung identisch, die durch die Kühldeckenelemente abtransportiert wird. Normiert man diese Leistung auf die aktive Fläche der Kühldeckenelemente, so erhält man die Kühlleistung $\dot{Q}$.

Die Kühlleistung wird bei 3 verschiedenen Untertemperaturen bestimmt und daraus die Leistungskurve des Kühldeckenelementes bestimmt:

$$\dot{Q} = K \Delta T_U^n$$

Aus der Leistungskurve wird die Nenn-Kühlleistung bei $\Delta T_U = 8K$ bestimmt. Die Norm schreibt vor, dass für Kühldeckenelemente eine Nenn-Kühlleistung von mindestens 35W/m$^2$ erreicht werden muss.

Das so hergestellte Heiz-/Kühlelement wies folgende technische Daten auf:

Die Nenn-Kühlleistung des Beispiels war ausgezeichnet. Der Wärmeleitungswiderstand zwischen Rohren und Deckenelement ergibt sich aus der Leistungsmessung und konnte mit kleiner 10m$^2$K/kW ermittelt werden. Dieser Wert ist sehr günstig, da der Wärmeleitungswiderstand zwischen den Rohren und dem Deckenelement kleiner 50m$^2$K/kW, bevorzugt kleiner 20 m$^2$K/kW und besonders bevorzugt 10 m$^2$K/kW sein sollte.

Weitere Beispiele für erfindungsgemäße Deckenelemente besitzen die folgenden Eigenschaften:

1) Kühldeckenelement mit metallisch matter Oberfläche

| | |
|---|---|
| Substrat | 5005 Al-Mg1 |
| Rauigkeit Ra | 0,25$\mu$m $\pm$ 0,1 $\mu$m |
| Dicke Platte | 1mm |
| Dicke Anodisierung | 4 $\mu$m |
| Farbe | Metallisch |
| Farbwerte Lab | |
| Totale Reflexion nach DIN 5036-3 | 75 - 79% |
| Diffuse Reflexion nach DIN 5036-3 | > 77% |
| Thermische Emission (100°C) | > 73% |
| Rohre | Kupfer 10X0,5mm |
| Rohrachsenabstand | 80mm |
| Rohrgeometrie | Mäander |

2) Kühldeckenelement mit aluminiumblanker matter Oberfläche

| | |
|---|---|
| Substrat | 5005 Al-Mg1 |
| Rauigkeit Ra | 0,20$\mu$m $\pm$ 0,1 $\mu$m |
| Dicke Platte | 1mm |
| Dicke Anodisierung | 4 $\mu$m |
| Farbe | Aluminium blank |
| Farbwerte Lab | |

(fortgesetzt)

| | |
|---|---|
| Totale Reflexion nach DIN 5036-3 | 80 - 83% |
| Diffuse Reflexion nach DIN 5036-3 | > 76% |
| Thermische Emission (100°C) | > 73% |
| Rohre | Kupfer 10X0,75mm |
| Rohrachsenabstand | 100mm |
| Rohrgeometrie | Mäander |

3) Kühldeckenelement mit spiegelnder Oberfläche

| | |
|---|---|
| Substrat | Al 1090 |
| Rauigkeit Ra | 20nm $\pm$ 10nm |
| Dicke Platte | 1 mm |
| Dicke Anodisierung | 3 $\mu$m |
| Farbe | Aluminium blank |
| Farbwerte Lab | |
| Totale Reflexion nach DIN 5036-3 | 85 - 87% |
| Diffuse Reflexion nach DIN 5036-3 | < 15% |
| Thermische Emission (100°C) | > 75% |
| Rohre | Kupfer 12X0,75mm |
| Rohrachsenabstand | 120mm |
| Rohrgeometrie | Mäander |

4) Kühldeckenelement mit matter goldener Oberfläche

| | |
|---|---|
| Substrat | 5005 Al-Mg1 |
| Rauigkeit Ra | 0,25$\mu$m $\pm$ 0,1 $\mu$m |
| Dicke Platte | 0,5mm |
| Dicke Anodisierung | 5 $\mu$m |
| Farbe | Gold |
| Farbwerte Lab | $L* = 81; a* = 4; b* = 40$ (alle Werte $\pm$ 2) |
| Totale Reflexion nach DIN 5036-3 | 55 - 60% |
| Diffuse Reflexion nach DIN 5036-3 | > 50% |
| Thermische Emission (100°C) | 70 - 75% |
| Rohre | Kupfer 8X0,5mm |
| Rohrachsenabstand | 80mm |
| Rohrgeometrie | Spirale |

5) Kühldeckenelement mit matter dunkelroter Oberfläche

| | |
|---|---|
| Substrat | 5005 Al-Mg1 |

(fortgesetzt)

| | |
|---|---|
| Rauigkeit Ra | 0,25$\mu$m $\pm$ 0,1 $\mu$m |
| Dicke Platte | 0,7mm |
| Dicke Anodisierung | 5 $\mu$m |
| Farbe | Dunkelrot |
| Farbwerte Lab | L* = 64; a* = 46; b* = -6 (alle Werte $\pm$ 2) |
| Totale Reflexion nach DIN 5036-3 | 25 - 30% |
| Diffuse Reflexion nach DIN 5036-3 | > 20% |
| Thermische Emission (100°C) | 65 - 70% |
| Rohre | Kupfer 6X0,3mm |
| Rohrachsenabstand | 80mm |
| Rohrgeometrie | Harfe |

6) Kühldeckenelement mit spiegelnd blauer Oberfläche

| | |
|---|---|
| Substrat | Al 1080 |
| Rauigkeit Ra | 0,30nm $\pm$ 10nm |
| Dicke Platte | 0,7mm |
| Dicke Anodisierung | 6 $\mu$m |
| Farbe | Blau |
| Farbwerte Lab | L* = 67; a* = -24; b* = -35 (alle Werte $\pm$ 2) |
| Totale Reflexion nach DIN 5036-3 | 35 - 40% |
| Diffuse Reflexion nach DIN 5036-3 | < 20% |
| Thermische Emission (100°C) | 55 - 60% |
| Rohre | Kupfer 12X0,75mm |
| Rohrachsenabstand | 100mm |
| Rohrgeometrie | Harfe |

7) Kühldeckenelement mit metallisch matter Oberfläche

| | |
|---|---|
| Substrat | Edelstahl |
| Rauigkeit Ra | 0,25$\mu$m $\pm$ 0,1 $\mu$m |
| Dicke Platte | 0,4mm |
| PVD Farb-Schicht | Nein |
| Emission erhöhende Beschichtung | Sol-Gel SiO$_x$ |
| Dicke Beschichtung | 3 - 4$\mu$m |
| Farbe | metallisch dunkel |
| Farbwerte Lab | |
| Totale Reflexion nach DIN 5036-3 | |
| Diffuse Reflexion nach DIN 5036-3 | |

(fortgesetzt)

| | |
|---|---|
| Thermische Emission (100°C) | > 55% |
| Rohre | Edelstahl 6X0,5mm |
| Rohrachsenabstand | 80mm |
| Rohrgeometrie | Harfe |

8) Kühldeckenelement mit metallisch matter Oberfläche

| | |
|---|---|
| Substrat | 5005 Al-Mg1 |
| Rauigkeit Ra | $0,25\mu m \pm 0,1 \mu m$ |
| Dicke Platte | 1mm |
| Dicke Anodisierung | $0\mu m$ |
| PVD Farb-Schicht | Nein |
| Emission erhöhende Beschichtung | Sol-Gel $SiO_x$ |
| Dicke Beschichtung | $3 - 4\mu m$ |
| Farbe | metallisch dunkel |
| Farbwerte Lab | |
| Totale Reflexion nach DIN 5036-3 | 75 - 79% |
| Diffuse Reflexion nach DIN 5036-3 | > 77% |
| Thermische Emission (100°C) | > 50% |
| Rohre | Aluminium 10X1,0mm |
| Rohrachsenabstand | 100mm |
| Rohrgeometrie | Mäander |

9) Kühldeckenelement mit farbiger matter Oberfläche

| | |
|---|---|
| Substrat | Edelstahl |
| Rauigkeit Ra | $0,25\mu m \pm 0,1 \mu m$ |
| Dicke Platte | 0,3mm |
| PVD Farb-Schicht | $NiV/CrO_xN_y/ZrO_x$ |
| Emission erhöhende Beschichtung | Fluoropolymerlack |
| Dicke Beschichtung | $6\mu m$ |
| Farbe | Lila |
| Farbwerte Lab | L* = 16; a* = 30; b* = -37 (alle Werte $\pm$ 2) |
| Totale Reflexion nach DIN 5036-3 | 3-5% |
| Diffuse Reflexion nach DIN 5036-3 | < 3% |
| Thermische Emission (100°C) | > 55% |
| Rohre | Edelstahl 6X0,5mm |
| Rohrachsenabstand | 80mm |
| Rohrgeometrie | Harfe |

10) Kühldeckenelement mit farbig matter Oberfläche

| Substrat | 5005 Al-Mg1 |
|---|---|
| Rauigkeit Ra | $0,20\mu m \pm 0,1\ \mu m$ |
| Dicke Aluminiumplatte | 1,5mm |
| Dicke Anodisierung | $0\mu m$ |
| PVD Farb-Schicht | $NiV/CrO_xN_y/SiO_x$ |
| Emission erhöhende Beschichtung | Sol-Gel $SiO_x$ |
| Dicke Beschichtung | $3 - 4\mu m$ |
| Farbe | Gold |
| Farbwerte Lab | $L^* = 55; a^* = 9; b^* = 44$ (alle Werte $\pm 2$) |
| Totale Reflexion nach DIN 5036-3 | 20 - 30% |
| Diffuse Reflexion nach DIN 5036-3 | < 20% |
| Thermische Emission (100°C) | > 60% |
| Rohre | Aluminium 8X0,75mm |
| Rohrachsenabstand | 80mm |
| Rohrgeometrie | Spirale |

**Patentansprüche**

1. Deckenelement aus oder mit einer Metallplatte, ausgewählt unter Platten aus Aluminium und/oder einer Aluminiumlegierung, Stahl, Weißblech und Edelstahl, deren zum Raum hin gerichtete Seite eine Schicht aufweist, derart, dass die Platte auf dieser Seite im Bereich der thermischen Infrarotstrahlung ($2,0$ bis $50\mu m$) eine thermische Emission bei 100°C nach ISO 22975-3:2014; Annex A.2 von mindestens 50% besitzt, und deren dem Raum abgewandte Seite von dem Metall der Platte selbst gebildet wird, die außer einer möglichen natürlichen Oxidhaut im Falle von Platten aus Aluminium und/oder einer Aluminiumlegierung keine Beschichtung aufweist, **dadurch gekennzeichnet, dass** die genannte Metallplatte aus Aluminium oder einer Aluminiumlegierung besteht, die auf ihrer dem Raum zugewandten Seite eine Anodisierungschicht von mindestens $1\ \mu m$ aufweist, oder die genannte Metallplatte auf ihrer dem Raum zugewandten Seite eine mindestens $2\ \mu m$ dicke, transparente Schicht aus einem Fluorkohlenwasserstoffketten enthaltenden organischen Polymer oder aus durch das Sol-Gel-Verfahren erhaltenem Siliciumoxid als einzige Schicht oder als äußerste Schicht eines Schichtstapels aufweist, der weiterhin eine oder mehrere gesputterte Schichten aufweist oder aus den genannten Schichten besteht, und dass die Metallplatte mindestens auf der dem Raum zugewandten Seite elektropoliert ist.

2. Deckenelement nach Anspruch 1, dessen Anodisierungsschicht eine Dicke zwischen 1 und 10 $\mu m$, vorzugsweise zwischen 2 und 6 $\mu m$ besitzt.

3. Deckenelement nach einem der Ansprüche 1 oder 2, dessen Anodisierungsschicht zusätzlich mit anorganischen und/oder organischen Pigmenten farbig pigmentiert ist.

4. Deckenelement nach einem der Ansprüche 1 oder 3 mit einer Anodisierungsschicht, die eine Dicke zwischen 3,5 und 10 $\mu m$ besitzt, wobei das Deckenelement eine thermische Emission bei 100°C nach ISO 22975-3:2014; Annex A.2 von mindestens 70% aufweist.

5. Deckenelement nach einem der voranstehenden Ansprüche , worin der Schichtstapel eine farbige Schicht aus einem gesputterten Material aufweist, ausgewählt unter Si, $SiO_xN_y$, $TiO_xN_yC_z$, $TiAl_sN_yO_x$, $CrO_xN_yC_z$ und $ZrO_xN_yC_z$, worin x, y und z so gewählt sind, das die Verbindungen unterstöchiometrisch bezüglich der Summe der Anionen und vorzugsweise auch bezüglich des Sauerstoffs sind, wobei x>0 ist und y und z jeweils $\geq 0$ sind, und s 20 bis 80 Atom-% bedeutet, bezogen auf das Titan.

**6.** Deckenelement nach Anspruch 5, worin der Schichtstapel zusätzlich entweder eine gesputterte Haftschicht aufweist, die sich unmittelbar auf der Oberfläche der Metallplatte befindet und ausgewählt ist unter den Metallen Cr, Ti und Al sowie einer Nickellegierung, bevorzugt einer Legierung mit Vanadium, Chrom oder Aluminium, und/oder eine gesputterte Haftschicht aufweist, die sich zwischen der farbigen Schicht aus gesputtertem Material und der mindestens 2 $\mu$m dicken, transparenten, äußersten Schicht befindet und ausgewählt ist unter jeweils stöchiometrischem oder bezüglich des Sauerstoffs unterstöchiometrischem $SiO_x$, $TiO_x$ und mit Aluminiumoxid dotiertem Zinkoxid (ZAO).

**7.** Deckenelement nach einem der voranstehenden Ansprüche, worin die genannte Metallplatte eine Dicke zwischen 0,1 und 3mm besitzt.

**8.** Deckenelement nach einem der voranstehenden Ansprüche, **dadurch gekennzeichnet, dass** die Oberfläche mit einem Lack beschichtet ist.

**9.** Wärme- und/oder Kühldeckenelement, umfassend ein Deckenelement nach einem der voranstehenden Ansprüche sowie mindestens ein rückseitig auf diesem Deckenelement befestigtes Rohr, das für die Zirkulation eines Wärmeträgermediums ausgelegt ist.

**10.** Wärme- und/oder Kühldeckenelement nach Anspruch 9, worin das mindestens eine Rohr mit Hilfe von formschlüssig um die Rückseite des Rohres gelegten Fügestreifen in seiner Position gehalten wird, wobei die Fügestreifen auf beiden Seiten des Rohres an die Rückseite des Deckenelements angeschweißt sind.

**11.** Wärme- und/oder Kühldeckenelement nach Anspruch 9 oder 10, worin die Fügestreifen zusätzlich auf der dem Deckenelement abgewandten Seite des Rohres an dessen Oberfläche angeschweißt sind.

**12.** Wärme- und/oder Kühldeckenelement nach einem der Ansprüche 9 bis 11, **dadurch gekennzeichnet, dass** der Fügestreifen aus einem Metall besteht, ausgewählt unter Stahl, Edelstahl, Aluminium, einer Aluminiumlegierung, Kupfer, einer Kupferlegierung und Messing, und vorzugsweise aus Aluminium besteht.

**13.** Wärme- und/oder Kühldeckenelement nach einem der Ansprüche 9 bis 12, **dadurch gekennzeichnet, dass** die dem Deckenelement zugewandte Seite des mindestens einen Rohres unter Ausbildung einer vergrößerten Kontaktfläche zwischen dem Rohr und dem Deckenelement abgeflacht ist.

**14.** Wärme- und/oder Kühldeckenelement nach einem der Ansprüche 9 bis 13, zusätzlich umfassend im Deckenelement befindliche Leuchtmittel, insbesondere LED-Leuchten, Feuersensoren, Sprinklereinrichtungen und/oder Lautsprecherboxen.

**15.** Wärme- und/oder Kühldeckenelement, umfassend ein Deckenelement nach einem der Ansprüche 9 bis 14, in das regelmäßig oder in einem gewünschten Muster schallschluckende Vertiefungen oder schallschluckende durchgehende Öffnungen eingebracht sind.

**Claims**

**1.** A ceiling element made of or provided with a metal plate selected from plates made of aluminum and/or an aluminum alloy, steel, tinplate and stainless steel, whose side facing toward the room has a layer such that the plate on this side has a thermal emission at 100°C according to ISO 22975-3:2014; Annex A.2 of at least 50% in the range of thermal infrared radiation (2,0 to 50$\mu$m), and whose side facing away from the room is formed by the metal of the plate itself which, apart from a possible natural oxide film in the case of plates made of aluminum and/or an aluminum alloy, has no coating, **characterized in that** said metal plate consists of aluminum or an aluminum alloy and has an anodizing layer of at least 1 $\mu$m on its side facing toward the room, or said metal plate has on its side facing toward the room an at least 2$\mu$m thick, transparent layer of an organic polymer containing hydrofluorocarbon chains or of a silicon oxide obtained by a sol-gel process as a single layer or as the outermost layer of a layer stack, which furthermore has one or more sputtered layers or consists of said layers, and that the metal plate is electropolished at least on the side facing toward the room.

**2.** The ceiling element according to claim 1, wherein the anodizing layer has a thickness of between 1 and 10 $\mu$m, preferably between 2 and 6 $\mu$m.

3. The ceiling element according to any one of claims 1 or 2, wherein the anodizing layer further has a colored pigmentation with inorganic and/or organic pigments.

4. The ceiling element according to any one of claims 1 or 3 having an anodizing layer which has a thickness between 3.5 and 10 $\mu$m, wherein the ceiling element has a thermal emission at 100°C according to ISO 22975-3:2014; Annex A.2, of at least 70%.

5. The ceiling element according to any one of the preceding claims, wherein the layer stack has a colored layer of a sputtered material selected from Si, $SiO_xN_y$, $TiO_xN_yC_z$, $TiAl_sN_yO_x$, $CrO_xN_yC_z$ and $ZrO_xN_yC_z$, wherein x, y and z are selected so that the compounds are sub-stoichiometric with respect to the sum of the anions and preferably also with respect to the oxygen, wherein x is >0 and y and z are each $\geq$0, and s is 20 to 80 atomic%, based on the titanium.

6. The ceiling element according to claim 5, wherein the layer stack additionally comprises a sputtered adhesion layer which is located directly on the surface of the metal plate and selected from the metals Cr, Ti and Al as well as a nickel alloy, preferably an alloy with vanadium, chromium or aluminum, and/or comprises a sputtered adhesion layer which is located between the colored layer of a sputtered material and the at least 2 $\mu$m thick, transparent, outermost layer and is selected from stoichiometric or, with respect to the oxygen, sub-stoichiometric $SiO_x$, $TiO_x$ and zinc oxide doped with aluminum oxide (ZAO).

7. The ceiling element according to any one of the preceding claims, wherein said metal plate has a thickness of between 0.1 and 3mm.

8. The ceiling element according to any one of the preceding claims, **characterized in that** the surface is coated with a lacquer.

9. A heating and/or cooling ceiling element, comprising a ceiling element according to any one of the preceding claims and at least one pipe attached to the back side of this ceiling element, wherein the pipe is designed for the circulation of a heat transfer medium.

10. The heating and/or cooling ceiling element according to claim 9, wherein the at least one pipe is held in position with the aid of joining strips arranged form-fit around the rear side of the pipe, wherein the joining strips are welded to the rear side of the ceiling element on both sides of the pipe.

11. The heating and/or cooling ceiling element according to claim 9 or 10, wherein the joining strips are additionally welded to the surface of the tube on the side facing away from the ceiling element.

12. The heating and/or cooling ceiling element according to any one of claims 9 to 11, **characterized in that** the joining strip consists of a metal selected from steel, stainless steel, aluminum, an aluminum alloy, copper, a copper alloy and brass, and preferably consists of aluminum.

13. The heating and/or cooling ceiling element according to any one of claims 9 to 12, **characterized in that** the side of the at least one pipe facing toward the ceiling element is flattened in order to form an enlarged contact area between the pipe and the ceiling element.

14. The heating and/or cooling ceiling element according to any one of claims 9 to 13, which further comprises illuminants, in particular LED lamps, fire sensors, sprinkler devices and/or loudspeakers in the ceiling element.

15. A heating and/or cooling ceiling element, comprising a ceiling element according to any one of claims 9 to 14, into which sound-absorbing recesses or sound-absorbing through-holes are arranged regularly or in a desired pattern.

**Revendications**

1. Elément de plafond composé ou pourvu d'une plaque métallique, sélectionnée parmi des plaques en aluminium et/ou en un alliage d'aluminium, en acier, en fer-blanc et en acier allié, dont la face orientée vers le local présente une couche, de telle manière que la plaque présente sur cette face dans la plage du rayonnement thermique infrarouge (2,0 $\mu$m à 50 $\mu$m) une émission thermique d'au moins 50 % à 100°C selon la norme ISO 22975-3:2014; Annexe A.2, et dont la face orientée à l'opposé du local est constituée du métal de la plaque elle-même, qui ne comporte aucun revêtement, sauf une éventuelle pellicule d'oxyde naturelle, dans le cas de plaques en aluminium et/ou en un alliage d'aluminium, **caractérisé en ce que** ladite plaque métallique se compose d'aluminium ou d'un alliage d'aluminium, qui présente sur sa face orientée vers le local une couche d'anodisation d'au moins 1 $\mu$m, ou ladite plaque métallique présente sur sa face orientée vers le local une couche transparente d'une épaisseur d'au moins 2 $\mu$m en un polymère organique contenant des chaînes d'hydrocarbure fluoré ou en dioxyde de silicium obtenu par le procédé sol-gel sous la forme d'une couche unique ou de la couche le plus extérieur d'un empilement de couches déposées par pulvérisation cathodique ou se compose desdites couches, et **en ce que** la plaque métallique est électro-polie au moins sur la face orientée vers le local.

2. Elément de plafond selon la revendication 1, dont la couche d'anodisation présente une épaisseur comprise entre 1 $\mu$m et 10 $\mu$m, de préférence entre 2 $\mu$m et 6 $\mu$m.

3. Elément de plafond selon une des revendications 1 ou 2, dont la couche d'anodisation est en plus pigmentée de façon colorée avec des pigments inorganiques et/ou organiques.

4. Elément de plafond selon une des revendications 1 ou 3, comprenant une couche d'anodisation, qui présente une épaisseur comprise entre 3,5 $\mu$m et 10 $\mu$m, dans lequel l'élément de plafond présente une émission thermique à 100°C selon la norme ISO 22975-3:2014; Annexe A.2 d'au moins 70 %.

5. Elément de plafond selon l'une quelconque des revendications précédentes, dans lequel l'empilement de couches présente une couche colorée en un matériau déposé par pulvérisation cathodique, sélectionné parmi Si, $SiO_xN_y$, $TiO_xN_yC_z$, $TiAl_sN_yO_x$, $CrO_xN_yC_z$ et $ZrO_xN_yC_z$, dans lequel x, y et z sont sélectionnés de telle manière que les liaisons soient sous-stœchiométriques par rapport à la somme des anions et de préférence aussi par rapport à l'oxygène, dans lequel x est >0 et y et z sont chacun $\geq$0, et s signifie 20 % à 80 % atomiques, rapportés au titane.

6. Elément de plafond selon la revendication 5, dans lequel l'empilement de couches présente en outre soit une couche adhésive déposée par pulvérisation cathodique, qui se trouve directement sur la surface de la plaque métallique et qui est sélectionnée parmi les métaux Cr, Ti et Al ainsi qu'un alliage de nickel, de préférence un alliage contenant du vanadium, du chrome ou de l'aluminium, et/ou présente une couche adhésive déposée par pulvérisation cathodique, qui se trouve entre la couche colorée en matériau déposé par pulvérisation cathodique et la couche transparente la plus extérieure d'une épaisseur d'au moins 2 $\mu$m et qui est sélectionnée parmi le $SiO_x$, le $TiO_x$ et l'oxyde de zinc (ZAO) dopé à l'oxyde d'aluminium, respectivement stœchiométriques ou sous-stœchiométriques par rapport à l'oxygène.

7. Elément de plafond selon l'une quelconque des revendications précédentes, dans lequel ladite plaque métallique présente une épaisseur comprise entre 0,1 mm et 3 mm.

8. Elément de plafond selon l'une quelconque des revendications précédentes, **caractérisé en ce que** la surface est revêtue d'une peinture.

9. Elément de plafond chauffant et/ou réfrigérant, comprenant un élément de plafond selon l'une quelconque des revendications précédentes, ainsi qu'au moins un tube fixé au dos de cet élément de plafond, qui est conçu pour la circulation d'un fluide caloporteur.

10. Elément de plafond chauffant et/ou réfrigérant selon la revendication 9, dans lequel ledit au moins un tube est maintenu dans sa position par des bandes de jonction posées en complémentarité de forme autour du côté arrière du tube, dans lequel les bandes de jonction sont soudées de part et d'autre du tube à la face arrière de l'élément de plafond.

11. Elément de plafond chauffant et/ou réfrigérant selon la revendication 9 ou 10, dans lequel les bandes de jonction sont soudées sur le côté du tube, à la surface de celui-ci, détourné de l'élément de plafond.

12. Elément de plafond chauffant et/ou réfrigérant selon l'une quelconque des revendications 9 à 11, **caractérisé en ce que** la bande de jonction se compose d'un métal, sélectionné parmi l'acier, l'acier allié, l'aluminium, un alliage d'aluminium, le cuivre ou un alliage de cuivre et le laiton, et se compose de préférence d'aluminium.

13. Elément de plafond chauffant et/ou réfrigérant selon l'une quelconque des revendications 9 à 12, **caractérisé en ce que** le côté dudit au moins un tube tourné vers l'élément de plafond est aplati avec formation d'une face de contact agrandie entre le tube et l'élément de plafond.

14. Elément de plafond chauffant et/ou réfrigérant selon l'une quelconque des revendications 9 à 13, comprenant en outre un moyen lumineux se trouvant dans l'élément de plafond, en particulier des lampes LED, des détecteurs d'incendie, des dispositifs d'arrosage et/ou des enceintes de haut-parleurs.

15. Elément de plafond chauffant et/ou réfrigérant comprenant un élément de plafond selon l'une quelconque des revendications 9 à 14, dans lequel sont ménagées, selon un motif désiré, des cavités d'insonorisation ou des ouvertures continues d'absorption du son.

Figur 1

18

Figur 2

EP 3 325 892 B1

Figur 3: Mäander-Verrohrung

Figur 4: Harfen-Verrohrung

Figur 5: Spiral-Verrohrung

| Thermische Emission erhöhende Beschichtung: Sol-Gel Siliciumoxid-Beschichtung oder Fluoropolymerlack |
| --- |
| **PVD Schicht 3:** $SiO_x$, $ZrO_x$, $TiO_x$ oder ZAO |
| **PVD Schicht 2:** Si, $SiO_xN_y$, $TiO_xN_yC_z$, $TiAl_sN_yO_x$ oder $CrO_xN_yC_z$ oder $ZrO_xN_yC_z$ |
| **PVD Schicht 1:** Cr, Ti, Al oder eine Nickellegierung |
| **Substrat:** Aluminium, Stahl, Weißblech oder Edelstahl |

Figur 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10061229 C1
- DE 29803663 U1
- JP 2505246 B
- JP S6352296 B
- WO 2011128118 A1
- GB 2382871 A1
- GB 2483484 A